# DEMANDE DE BREVET EUROPEEN

(11) **EP 0 645 775 A1**
(43) Date de publication de la demande: **29.03.1995**
(21) Numéro de dépôt: 94402151.8
(22) Date de dépôt: 28.09.1994
(51) Int. Cl.: G11C 19/00, G06F 7/00, G06F 5/06

(54) **Dispositif électronique de mémoire à accès séquentiel**

(30) Priorité: 29.09.1993 FR 9311604
(71) Demandeur: FRANCE TELECOM, F-75015 Paris (FR)
(72) Inventeur: Le Scan, Patrice, F-38190 Bernin (FR); Closse, Etienne, F-38000 Grenoble (FR); Conq, Bernard, F-38240 Meylan (FR)
(74) Mandataire: Casalonga, Axel

(57) **Abrégé**

Le dispositif comprend deux entrées (E1,E2) et deux sorties (S1,S2) de données, et une matrice de cellules de mémorisation (CMᵢⱼ) aptes à stocker chacune une donnée, le nombre de cellules dépendant de la taille du jeu de données à stocker séquentiellement, ainsi qu'un bus d'écriture de données (BEᵢⱼ) et un bus de lecture de données (PLᵢⱼ) pour chaque ligne (Lᵢ) de cellules de la matrice et sur lesquels sont connectées toutes les cellules de ladite ligne. Des moyens de commutation commandables (TE1...T_{3,2}) possédent un premier état dans lequel ils relient l'une des entrées de données (E1) au bus d'écriture (BE₁) d'une première ligne d'extrémité (L₁) de la matrice et l'une des sorties de données (S1) au bus de lecture de données (BL₃) de la ligne d'extrémité opposée (L₃), et un deuxième état dans lequel ils relient l'autre entrée de données (E2) au bus d'écriture (BE₃) de la ligne d'extrémité opposée (L3) et l'autre sortie de données (S2) au bus de lecture (BL₁) de ladite première ligne d'extrémité (L1). Ils relient dans leurs deux états le bus de lecture de chaque ligne au bus d'écriture de la ligne voisine. Enfin, des moyens (MG , BCLⱼ, BCEⱼ) commandent séquentiellement et cycliquement, par paires de colonnes de la matrice, l'écriture et la lecture, respectivement, de données dans toutes les cellules des deux colonnes de la paire concernée selon un ordre pour les rangs successifs desdites colonnes, prédéterminé et différent dans chacun des deux états.

## Description

L'invention concerne un dispositif électronique de mémoire à accès séquentiel.

Les mémoires de type "Premier Entré-Premier Sorti" (First In-First Out : FIFO en langue anglaise) ou de type "Dernier Entré-Premier Sorti" (Last In-First Out : LIFO en langue anglaise) sont des exemples de mémoires à accès séquentiel. Elles peuvent être réalisées à partir de structures de mémorisation du type mémoire vive statique (RAM statique) associées à un système d'adressage approprié ou encore à partir de registres à décalage. Néanmoins, de telles réalisations offrent des encombrements qui peuvent s'avérer importants et pénalisants dans l'intégration à très grande échelle (VLSI selon une abréviation en langue anglaise). Par ailleurs, si l'on veut réaliser une mémoire capable de présenter à la fois une structure du type FIFO et une structure du type LIFO, il est nécessaire d'utiliser une structure de mémorisation du type RAM, avec un système d'adressage encore plus élaboré, ce qui augmente encore son encombrement.

L'invention vise à proposer un dispositif électronique de mémoire à accès séquentiel capable de présenter une structure de type FIFO ou une structure de type LIFO, qui soit simple à réaliser, sans nécessiter de système d'adressage, et en offrant un encombrement minimum.

Selon une caractéristique générale de l'invention, un tel dispositif électronique de mémoire comprend au moins un ensemble-mémoire comportant :
- deux entrées et deux sorties de données,
- une matrice de cellules de mémorisation aptes à stocker chacune une donnée, le nombre de cellules dépendant de la taille du jeu de données à stocker séquentiellement,
- un bus d'écriture de données et un bus de lecture de données pour chaque ligne de cellules de la matrice et sur lesquels sont connectées toutes les cellules de ladite ligne,
- des moyens de commutation commandables possédant un premier état dans lequel ils relient l'une des entrées de données au bus d'écriture d'une première ligne d'extrémité de la matrice et l'une des sorties de données au bus de lecture de la ligne d'extrémité opposée, et un deuxième état dans lequel ils relient l'autre entrée de données au bus d'écriture de ladite ligne d'extrémité opposée et l'autre sortie de données au bus de lecture de ladite première ligne d'extrémité, les moyens de commutation reliant dans leurs deux états le bus de lecture de chaque ligne au bus d'écriture de la ligne voisine, et
- des moyens aptes à commander séquentiellement et cycliquement, par paires de colonnes de la matrice, l'écriture et la lecture, respectivement, de données dans toutes les cellules des deux colonnes de la paire concemée selon un ordre pour les rangs successifs desdites colonnes, prédéterminé et différent dans chacun des deux états.

Selon un mode de réalisation dans lequel le dispositif est cadencé par un signal d'horloge de fréquence prédéterminée, les moyens de commande comprennent un bus de commande d'écriture et un bus de commande de lecture pour chaque colonne de la matrice et sur lesquels sont respectivement connectées les entrées de commande d'écriture et de lecture de toutes les cellules de la colonne, ainsi que des mayens de génération aptes à générer à chaque coup d'horloge, sur un bus de commande d'écriture et un bus de commande de lecture associés à deux colonnes différentes, des signaux respectifs de commande d'écriture et de commande de lecture, selon la séquence de rangs correspondant à l'un ou l'autre des deux états.

Selon une première séquence, les signaux de commande de lecture et d'écriture peuvent parcourir simultanément et successivement les colonnes de rangs consécutifs de la matrice selon un premier sens, tandis que selon une deuxième séquence, les signaux de commande de lecture et d'écriture parcourent simultanément et successivement les colonnes de rangs consécutifs de la matrice selon un deuxième sens opposé au premier, le signal de commande de lecture étant décalé, dans les deux séquences, d'une colonne par rapport au signal de commande d'écriture dans le sens de parcours correspondant.

Selon un mode de réalisation de l'invention, les moyens de génération comportent pour chaque colonne un circuit de retard cadencé par ledit signal d'horloge, à l'entrée et à la sortie duquel sont respectivement connectés les bus de commande de lecture et d'écriture associés à ladite colonne, ainsi qu'un duplexeur commandable connecté entre chaque paire de circuits de retard consécutifs; l'une des entrées du duplexeur est reliée à la sortie de l'un des circuits de retard de ladite paire et au bus de commande d'écriture de la colonne correspondante, tandis que la sortie du duplexeur est reliée à l'entrée de l'autre circuit de retard de la paire ainsi qu'au bus de commande de lecture de la colonne correspondante; la sortie de cet autre circuit de retard est rebouclée sur l'autre entrée du duplexeur de la paire précédente; les deux positions différentes du duplexeur correspondent aux deux états des moyens de commutation; par ailleurs, les différents signaux de commande d'écriture et de lecture consistent en une information de commande se propageant cycliquement dans les moyens de génération au rythme du signal d'horloge.

Les cellules de mémorisation sont avantageusement des points-mémoires dynamiques à trois transistors, le bus de lecture d'une ligne étant relié au bus d'écriture de la ligne voisine par un inverseur.

Selon un mode de réalisation de l'invention, la matrice comporte n lignes et p+1 colonnes, le produit n.p représentant le nombre maximum de données à stocker.

Lorsque chaque donnée est un mot de b bits, le dispositif comprend alors avantageusement b ensembles-mémoires identiques disposés en parallèles, aptes à fonctionner de façon synchronisée, et destinés à stocker respectivement les b bits des données successives.

Le dispositif selon l'invention peut alors être utilisé en tant que mémoire de type "Premier Entré-Premier Sorti". Dans ce cas, on peut conférer aux moyens de commutation l'un quelconque de leurs deux états pendant le stockage du jeu de données considéré, puis après ce stockage, on maintient les moyens de commutation dans cet état.

Le dispositif peut également être utilisé comme une mémoire de type "Dernier Entré-Premier Sorti". Dans ce cas, on peut également conférer aux moyens de commutation l'un quelconque des deux états pendant le stockage du jeu de données. Cependant, après ce stockage, on fait passer les moyens de commutation dans leur autre état.

D'autres avantages et caractéristiques de l'invention apparaîtront à l'examen de la description détaillée d'un mode de réalisation de l'invention, nullement limitatif, et illustré sur les dessins, sur lesquels :
la figure 1 illustre schématiquement un mode de réalisation d'un dispositif selon l'invention composé d'une pluralité d'ensembles-mémoires, ou plans-mémoires,
la figure 2 est un synoptique schématique plus détaillé de l'un des plans-mémoires du dispositif,
la figure 3 illustre schématiquement un point-mémoire d'une cellule de la matrice d'un plan-mémoire,
les figures 4a à 4d illustrent une utilisation du dispositif en tant que mémoire de type FIFO, et,
les figures 5a à 5d illustrent une utilisation du dispositif en tant que mémoire du type LIFO.

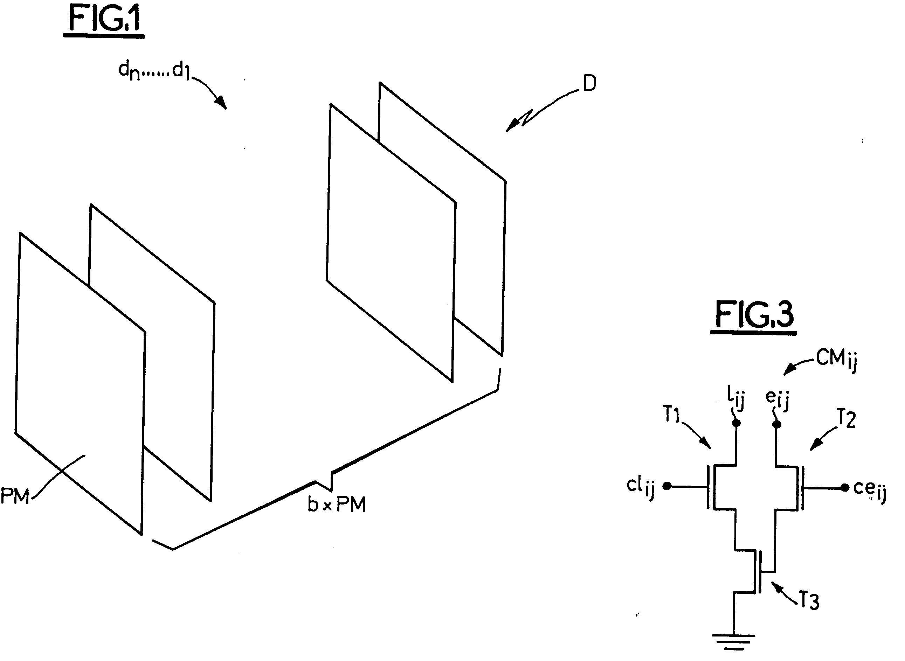

Tel qu'illustré sur la figure 1, le dispositif D est destiné à stocker séquentiellement un jeu de n données d1 ... dn composées ici chacune d'un mot de b bits. Aussi, le dispositif D comporte b ensembles-mémoires, ou plans-mémoires, PM disposés en parallèle, fonctionnant de manière synchronisée, et destiné à stocker respectivement les b bits de chaque donnée.

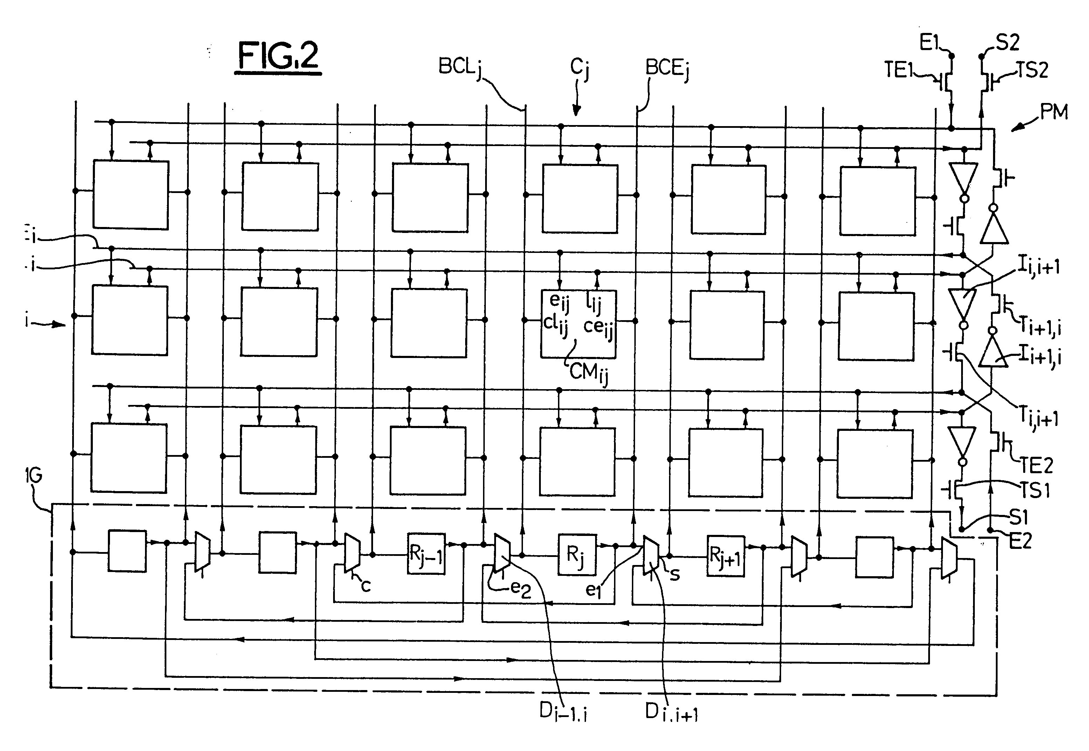

Si l'on se réfère plus particulièrement à la figure 2, on voit que chaque plan-mémoire PM comporte deux entrées de données E1 et E2 ainsi que deux sorties de données S1 et S2. Ce plan-mémoire comporte par ailleurs une matrice de cellules de mémorisation CMᵢⱼ aptes à stocker chacune une donnée du jeu de données, en l'espèce 1 bit. Cette matrice comporte des lignes Lᵢ et des colonnes Cⱼ de cellules. D'une façon générale, le nombre de cellules dépend de la taille du jeu de données à stocker séquentiellement. En principe, le nombre de cellules de la matrice est supérieur au nombre de données à stocker afin d'éviter un écrasement de certaines d'entre elles. En l'espèce, la matrice comporte n lignes et p+1 colonnes, le produit n.p représentant le nombre maximum de données à stocker.

Bien entendu, les termes "lignes" et "colonnes" ont été choisis ici pour désigner les deux directions habituelles d'une matrice, conformément à la représentation qui en est faite sur la figure 2, sans que l'utilisation de ces termes puisse préjuger de l'architecture réellement adoptée pour la réalisation matérielle, sur circuit intégré notamment.

Pour chaque ligne Lᵢ des cellules de la matrice, est prévu un bus d'écriture de données BEᵢ et un bus de lecture de données BLᵢ, sur lesquels sont connectées respectivement les entrées élémentaires de données eᵢⱼ et sorties élémentaires de données lᵢⱼ des cellules de la ligne Lᵢ.

La première entrée de données E1 est reliée au bus d'écriture de données BE₁ de la première ligne de la matrice, par l'intermédiaire d'un transistor à effet de champ TE1, tandis que le bus de lecture de données BL₁ de cette première ligne est relié à la deuxième sortie de données S2 par un transistor à effet de champ TS2, les transistors TE1 et TS2 étant de préférence des transistors commandés par des horloges complémentaires.

De même, la deuxième entrée de données E2 est reliée au bus d'écriture de données BE₃ de la ligne d'extrémité opposée de la matrice, en l'espèce la dernière ligne L₃, par l'intermédiaire d'un transistor à effet de champ TE2, tandis que le bus de lecture de données BL₃ de cette ligne L₃ est relié à la première sortie de données S1 par l'intermédiaire d'un transistor à effet de champ TS2, commandé par un signal d'horloge complémentaire de celui commandant le transistor TE2.

En outre, le bus de lecture de données BLᵢ (BLᵢ₊₁) de chaque ligne Lᵢ (Lᵢ₊₁) est relié au bus d'écriture BEᵢ₊₁ (BEᵢ) de la ligne voisine Lᵢ₊₁ (Lᵢ) par des transistors à effet de champ T_{i,i+1} (T_{i+1,i}). Les transistors T_{i,i+1} et T_{i+1,i} sont également de préférence commandés par des signaux d'horloge complémentaires.

Comme on le verra plus en détail ci-après, l'ensemble de ces transistors à effet de champ forme des moyens de commutation commandables à deux états.

Le plan-mémoire PM comporte par ailleurs un bus de commande d'écriture BCEⱼ et un bus de commande de lecture BCLⱼ pour chaque colonne Cⱼ de la matrice et sur lesquels sont respectivement connectées les entrées de commande d'écriture ceᵢⱼ et de lecture clᵢⱼ de toutes les cellules de cette colonne.

Par ailleurs, à chaque colonne de la matrice est associé un circuit de retard Rⱼ, tel qu'une bascule D, à l'entrée et à la sortie duquel sont respectivement connectés les bus de commande de lecture BCLⱼ et d'écriture BCEⱼ associés à la colonne concernée. En outre, un duplexeur commandable D_{j,j+1} est connecté entre chaque paire de circuits de retard consécutifs Rⱼ Rⱼ₊₁. L'une des entrées, référencée el du duplexeur correspondant est reliée à la sortie de l'un des circuits de retard de cette paire, en l'espèce le circuit Rⱼ, ainsi qu'au bus de commande d'écriture BCEⱼ de la colonne correspondante. La sortie s du duplexeur est reliée à l'entrée de l'autre circuit de retard de la paire, en l'espèce le circuit Rⱼ₊₁, ainsi qu'au bus de commande de lecture de la colonne correspondante. Enfin, la sortie de cet autre circuit de retard Rⱼ₊₁, est rebouclée sur l'autre entrée e2 du duplexeur associé à la paire précédente, en l'espèce la paire de circuits de retard Rⱼ₋₁ et Rⱼ. Les rangs des différentes colonnes ont été choisis ici croissants dans le sens de la gauche de la figure 2 vers la droite. Aussi, le circuit de retard de la dernière colonne précède le circuit de retard de la première colonne et forme avec celui-ci une paire à laquelle est associé le duplexeur représenté à droite sur la figure 2.

L'ensemble des duplexeurs et des circuits de retard forment des moyens de génération MG, qui, avec les bus de commande d'écriture et de lecture, permettent de commander séquentiellement et cycliquement, par paires de colonnes de la matrice, l'écriture et la lecture, respectivement, de données dans toutes les cellules des deux colonnes de la paire concernée, et ce, selon un ordre pour les rangs successifs desdites colonnes, prédéterminé et différent dans chacun des deux états des moyens de commutation T_{i,i+1} et T_{i+1,i}. L'entrée de commande c de chaque duplexeur permet de positionner celui-ci dans deux positions, à savoir une position haute dans laquelle l'entrée e1 est reliée à la sortie s et une position basse dans laquelle l'entrée e2 est reliée à la sortie s. Chacune des positions de ces duplexeurs correspond à l'un des états des moyens de commutation. La commande des moyens de commutation dans l'un ou l'autre de leurs états se fait par l'intermédiaire des grilles des transistors à effet de champ commandés de façon complémentaire et est fournie par des moyens externes au dispositif de mémoires et non représentés à des fins de simplification. De même, en correspondance de la commande des moyens de commutation, les moyens externes positionnent les duplexeurs sur leur position haute ou leur position basse.

Le dispositif, c'est-à-dire chaque plan-mémoire PM, est cadencé par un signal d'horloge de fréquence prédéterminée, à laquelle sont délivrées les données à stocker. Ainsi, les moyens de génération sont aptes à générer à chaque impulsion d'horloge, sur un bus de commande d'écriture et un bus de commande de lecture associés à deux colonnes différentes, les signaux respectifs de commande d'écriture et de commande de lecture selon la séquence de rangs correspondant à l'un ou l'autre des deux états.

Concrètement, les différents signaux de commande d'écriture et de lecture consistent en une information de commande, en l'espèce un bit de commande susceptible de prendre soit la valeur 0, soit la valeur 1, et se propageant cycliquement dans les moyens de génération MG, au rythme du signal d'horloge, et en suivant le cheminement défini par la position des duplexeurs selon l'état des moyens de commutation choisis.

Ainsi, selon une première séquence, les signaux de commande de lecture et d'écriture parcourent simultanément successivement les colonnes de rangs consécutifs de la matrice selon un premier sens prédéterminé, en l'espèce le sens de la gauche vers la droite, c'est-à-dire le sens des rangs croissants lorsque les duplexeurs sont en position haute, tandis que selon la deuxième séquence correspondant à une position basse des duplexeurs, les signaux de commande de lecture et d'écriture parcourent simultanément et successivement les colonnes dans le sens opposé. En outre, dans les deux séquences, le signal de commande de lecture est décalé d'une colonne par rapport au signal de commande d'écriture dans le sens du parcours considéré.

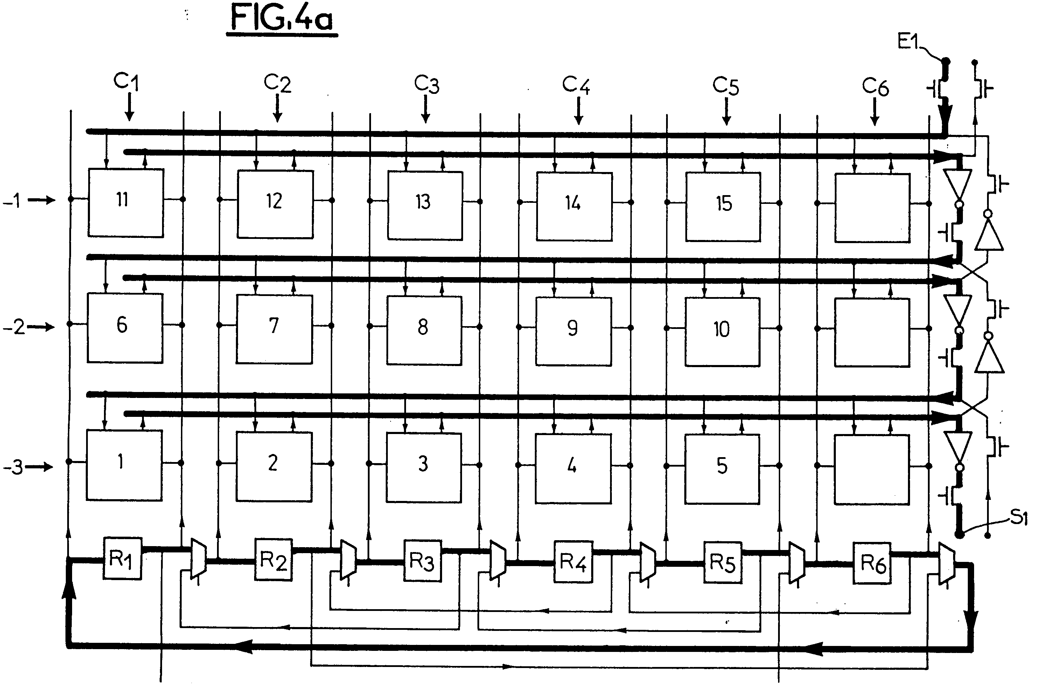

Bien que d'autres configurations puissent être en principe utilisées, les cellules de mémorisation sont constituées ici de points-mémoires dynamiques à trois transistors tels qu'illustrés sur la figure 3. Ainsi, le drain du transistor T1 forme la sortie élémentaire de données lᵢⱼ de la cellule CMᵢⱼ, tandis que la source de ce transistor T1 est reliée au drain du transistor T3, lui-même relié à la masse par l'intermédiaire de sa source. La source du transistor T2 forme l'entrée eᵢⱼ de données de la cellule CMᵢⱼ, tandis que le drain de ce transistor P2 est relié à la grille du transistor T3. Par ailleurs, les grilles respectives des transistors T1 et T2 forment les entrées de commande de lecture clᵢⱼ et de commande d'écriture ceᵢⱼ de la cellule CMᵢⱼ. Le stockage du bit mémorisé dans cette cellule s'effectue au niveau du transistor T3.

En raison de la structure intrinsèquement inverseuse du point-mémoire utilisée, il est prévu un inverseur I_{i+1,i} (I_{i,i+1}) reliant le bus de lecture d'une ligne au bus d'écriture de la ligne voisine.

L'homme du métier aura donc remarqué que chaque plan-mémoire PM forme une ligne à retard dynamique à 1 bit avec trois transistors par bit mémorisé, cette ligne à retard dynamique ne possédant pas de système d'adressage. Un gain d'encombrement est réalisé ainsi puisqu'une mémoire vive statique comporte 6 transistors et un système d'adressage, tandis qu'un registre à décalage comporte 8 transistors dans le cas d'un registre dynamique et 14 dans le cas d'un registre statique. Par ailleurs, cette ligne à retard dynamique va pouvoir être utilisée en tant que mémoire de type FIFO ou LIFO comme on va le décrire maintenant plus en détail sur un exemple particulier.

On suppose sur les figures 4a et suivantes que chaque plan mémoire comporte trois lignes L₁, L₂, L₃ et six colonnes C₁ ..., C₆, de façon à pouvoir stocker 15 données (en l'espèce 15 bits). Sur la figure 4a, les moyens de commutation sont représentés dans leur premier état et les duplexeurs dans leur position haute correspondant à la première séquence de cheminement des signaux de commande d'écriture et de lecture. Concrètement, les transistors TE1, T_{1,2}, T_{2,3} et TS1 sont passants, tandis que les transistors TE2, T_{3,2} et T_{2,1} et TS2 sont bloqués. La première entrée de données E1 est donc reliée au bus d'écriture BE₁ et le bus de lecture BL₃ est relié à la première sortie de données S1. On a représenté pour plus de clarté en caractères gras sur les figures 4a et suivantes, les cheminements autorisés compte tenu des positions des duplexeurs et de l'état des transistors. On suppose également que 15 données numérotées 1 à 15 ont été stockées préalablement dans le plan-mémoire avec, pendant cette phase de stockage, les moyens de commutation dans leur premier état et les duplexeurs en position haute. La donnée 1 a été la première donnée stockée et la donnée 15 la dernière.

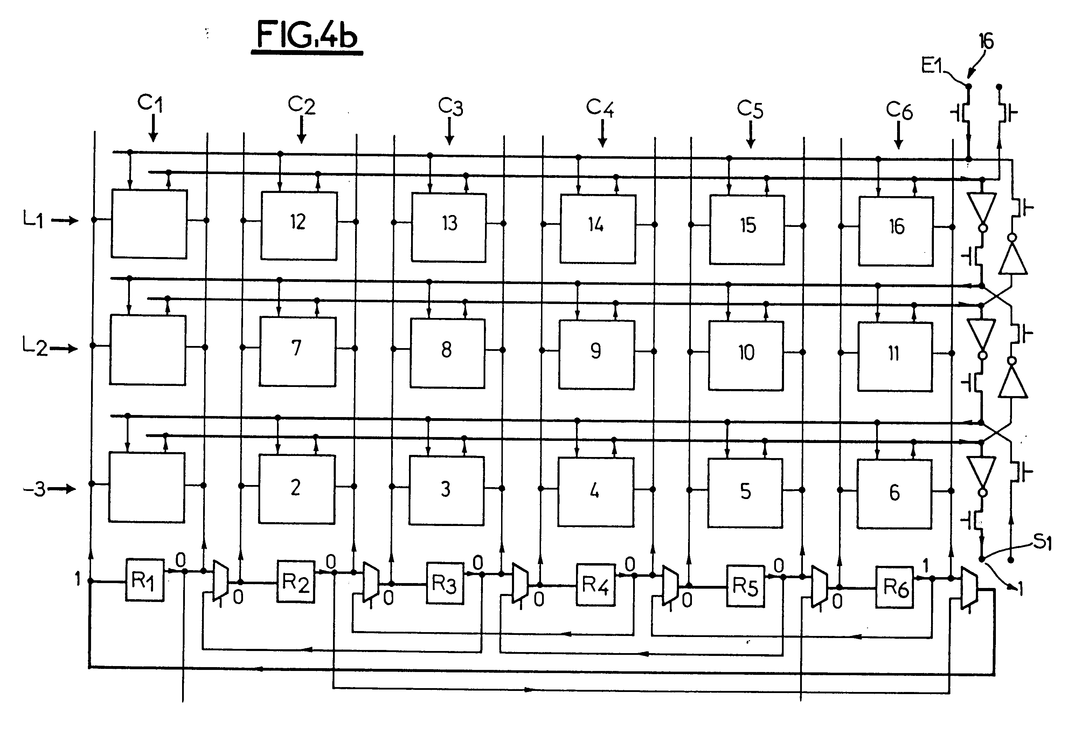

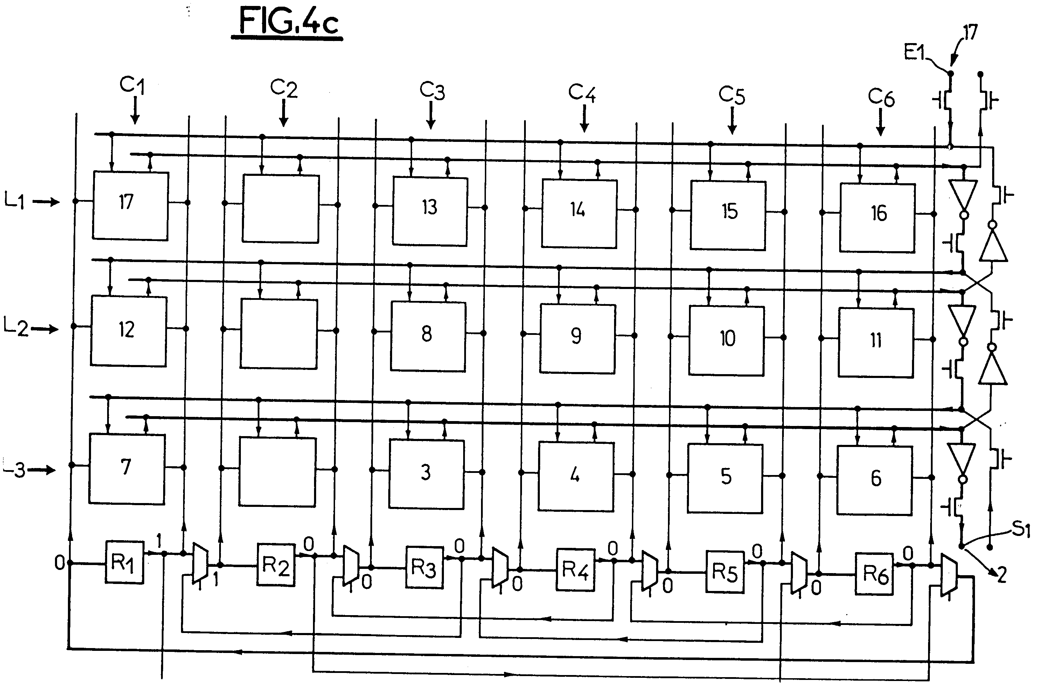

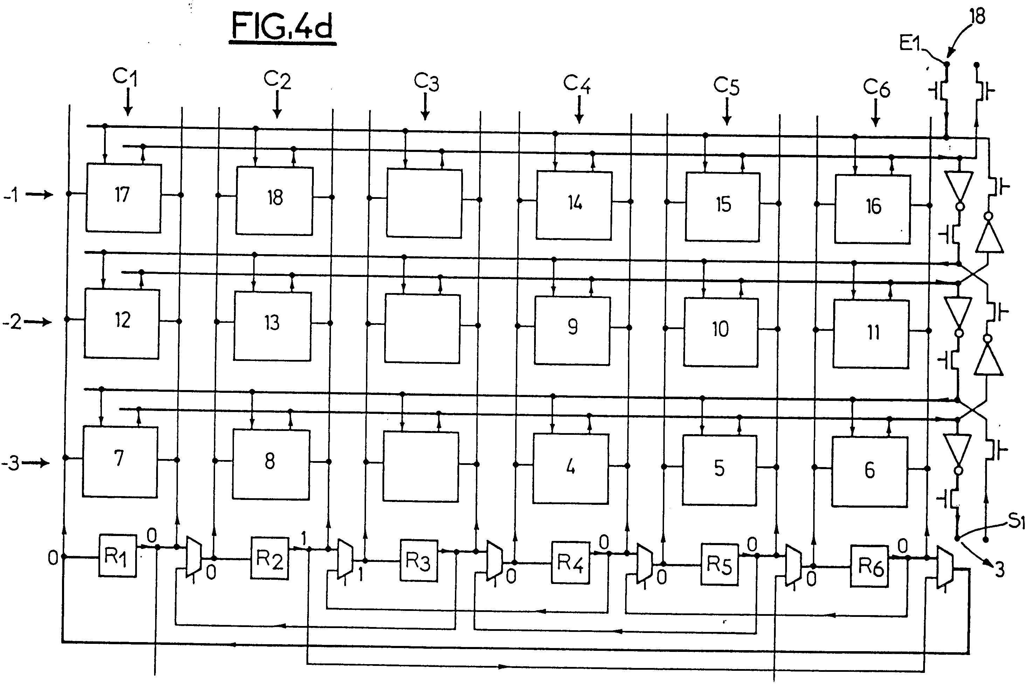

Sur la figure 4b, on suppose que l'information de commande, à son niveau 1, se trouve positionnée en sortie du registre R6 et par conséquent également en entrée du registre R1. Aussi, la donnée 1 qui était stockée dans la cellule CM₃₁ sort par la sortie S1, tandis qu'une éventuelle première autre donnée 16 d'un autre jeu de 15 données se présentant à l'entrée E1, est stockée dans la cellule CM₁₆. De par la liaison entre le bus de lecture d'une ligne et le bus d'écriture de la ligne voisine, la donnée 11, initialement dans la cellule CM₁₁ se retrouve stockée dans la cellule CM₂₆ et la donnée 6 se retrouve stockée dans la cellule CM₃₆. Au coup d'horloge suivant, l'information de commande se trouve positionnée (figure 4c) à la sortie du registre R1 et à l'entrée du registre R2, permettant d'une façon analogue, la sortie de la donnée 2 et l'entrée de la donnée 17. De même, au coup d'horloge suivant (figure 4d), l'information de commande, présente en sortie du registre R2 et en entrée du registre R3, permet la sortie de la donnée 3 et l'entrée de la donnée 18.

L'homme du métier remarque donc que la ligne à retard dynamique fonctionne ici comme une mémoire de type FIFO, puisque les données sortent dans l'ordre de leur stockage. Bien entendu, on aurait pu ne pas présenter un autre jeu de 15 données 16 à 30 en entrée E1 de la mémoire. Ceci étant, si on laisse se poursuivre le cycle de génération de signaux de commande d'écriture et de lecture, le nouveau jeu de 15 données 16 à 30 va remplacer l'ancien jeu de 15 données 1 à 15, puis ressortir dans le même ordre pour être éventuellement remplacé par un troisième jeu de données.

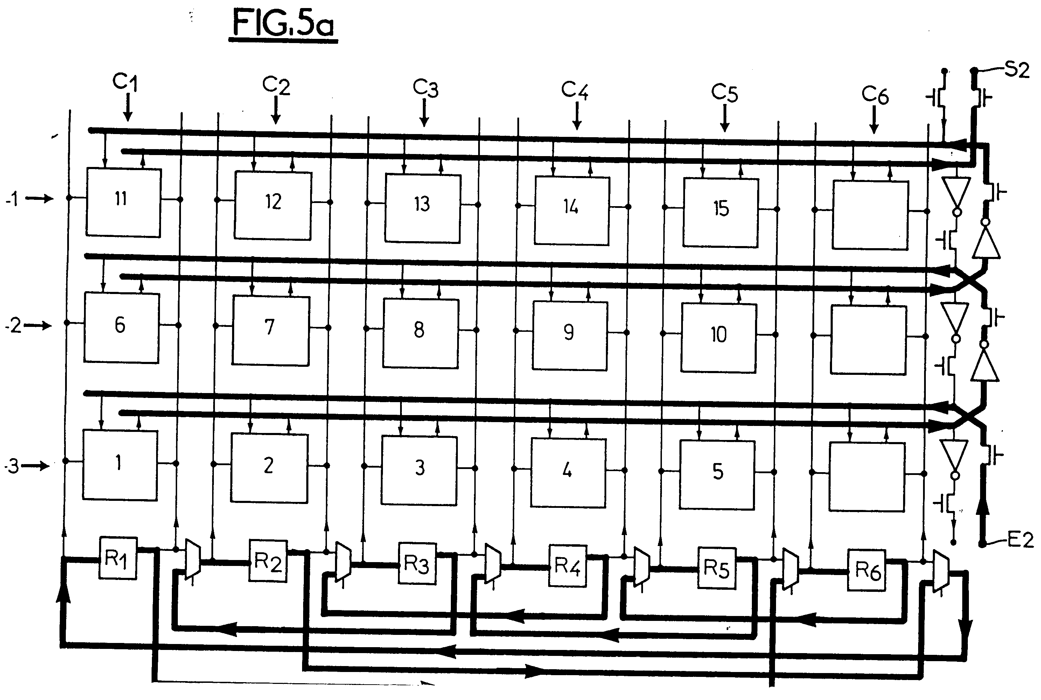

Sur la figure 5a, les moyens de commutation sont représentés dans leur deuxième état. Dans ce deuxième état, les transistors à effet de champ qui étaient bloqués dans le premier état sont passants dans cet état et inversement. Ainsi, la deuxième entrée de données E2 est cette fois-ci reliée au bus d'écriture de données BE₃ de la troisième ligne de la matrice, tandis que le bus de lecture BL₁ est relié à la deuxième sortie de données S2. Les duplexeurs sont cette fois-ci en position basse. Par analogie avec la figure 4a, les cheminements correspondant à cette configuration ont été représentés en caractères gras. On suppose également ici que le jeu de 15 données 1 à 15 a été préalablement stocké dans le plan-mémoire, alors que les moyens de commutation étaient dans leur premier état et les duplexeurs en position haute. En d'autres termes, la donnée 1 a été stockée la première et la donnée 15 a été stockée la dernière.

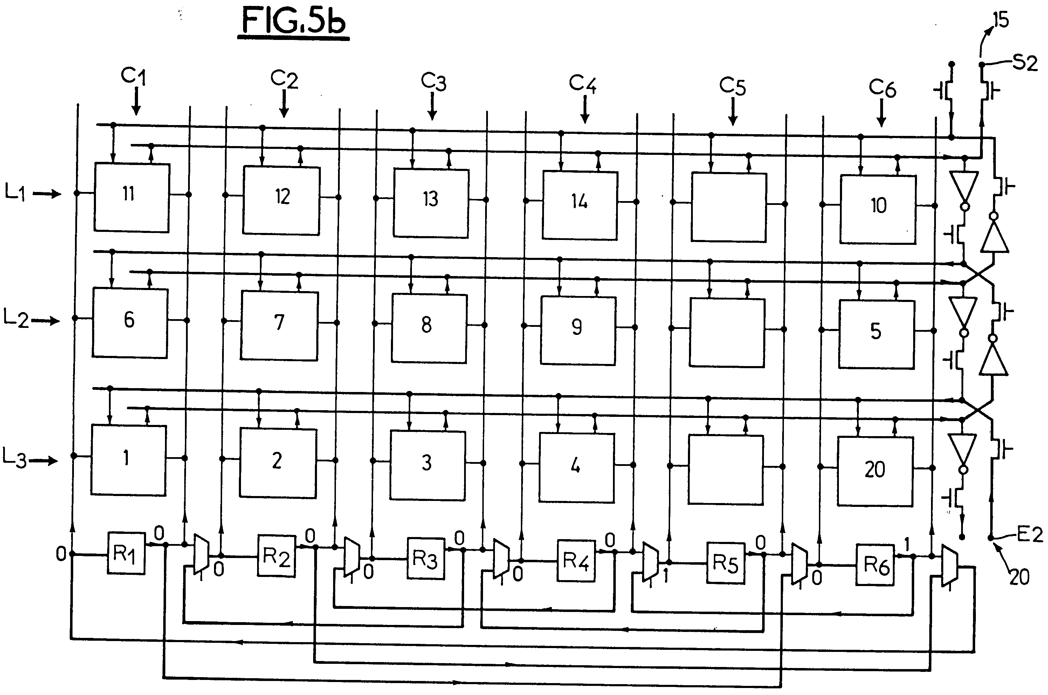

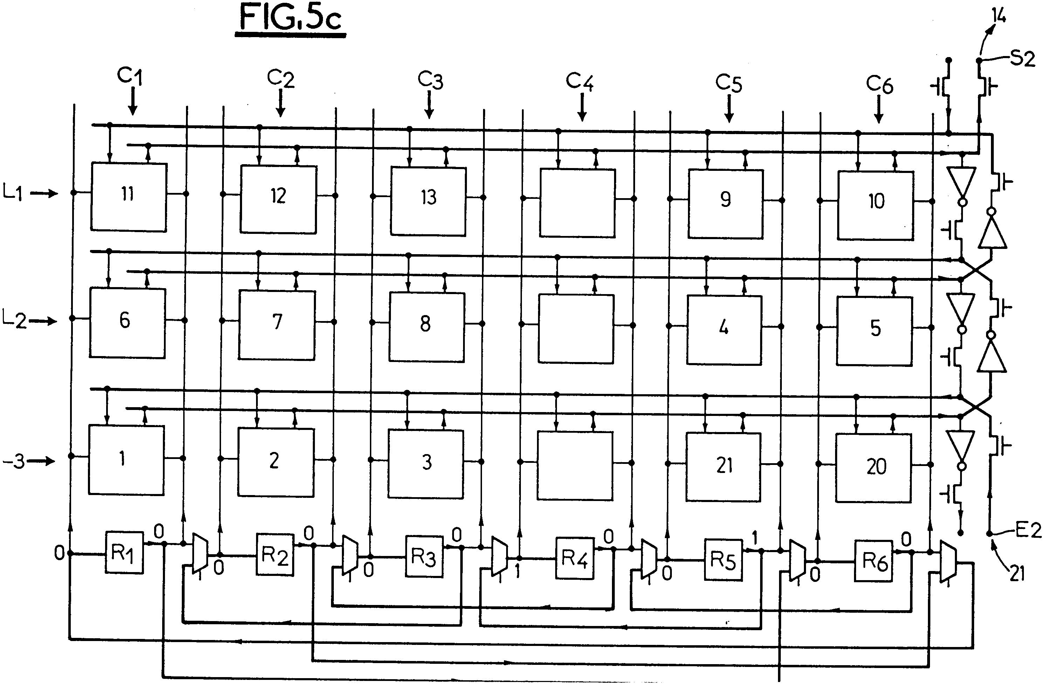

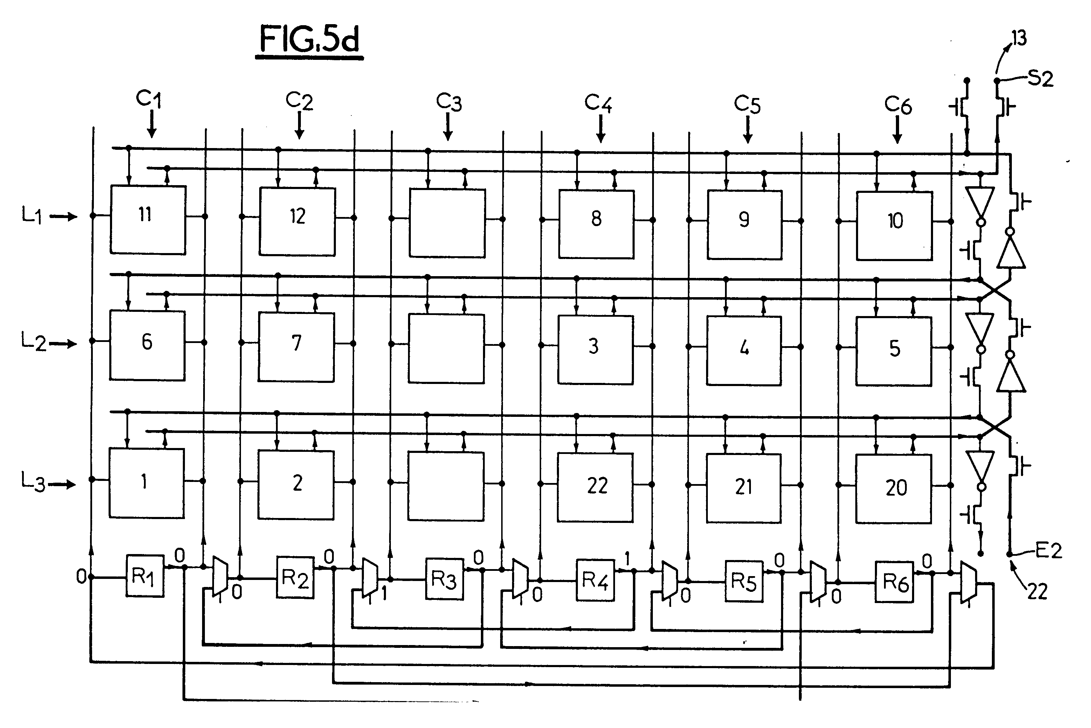

Si l'on suppose alors, comme illustré sur la figure 5b, que l'information de commande se situe en sortie du registre R6 et en entrée du registre R5, c'est la donnée 15 qui avait été stockée la dernière, qui sort la première. Par ailleurs, une éventuelle autre donnée 20 est stockée dansla cellule C₃₆. Lorsque le cheminement des informations de commande se poursuit conformément à cette deuxième séquence, la donnée 14 sort de la mémoire (figure 5c), et une nouvelle donnée 21 est stockée dans la cellule C₃₅, tandis qu'au coup d'horloge suivant (figure 5d), c'est la donnée 13 qui sort et une nouvelle donnée 22 qui est stockée dans la cellule CM₃₄.

L'homme du métier aura donc compris que par changement de l'état des moyens de commutation et de la position du duplexeur après stockage d'un jeu de données, la mémoire fonctionne comme une mémoire de type LIFO. Bien entendu, à terme, le nouveau jeu de données éventuelles 20 à 34 aura complètement remplacé l'ancien jeu de données 1 à 15. Cependant, si à l'issu de ce stockage du deuxième jeu de données, les moyens de commutation sont maintenus dans leur deuxième état et les duplexeurs en position basse, la mémoire fonctionnera comme une mémoire de type FIFO au regard de ce deuxième jeu de données.

## Revendications

1. Dispositif électronique de mémoire à accès séquentiel, caractérisé par le fait qu'il comprend au moins un ensemble-mémoire (PM) comportant :
- deux entrées (E1,E2) et deux sorties (S1,S2) de données,
- une matrice de cellules de mémorisation (CMᵢⱼ) aptes à stocker chacune une donnée, le nombre de cellules dépendant de la taille du jeu de données à stocker séquentiellement,
- un bus d'écriture de données (BEᵢⱼ) et un bus de lecture de données (PLᵢⱼ) pour chaque ligne (Lᵢ) de cellules de la matrice et sur lesquels sont connectées toutes les cellules de ladite ligne,
- des moyens de commutation commandables (TE1...T_{3,2}) possédant un premier état dans lequel ils relient l'une des entrées de données (E1) au bus d'écriture (BE₁) d'une première ligne d'extrémité (L₁) de la matrice et l'une des sorties de données (S1) au bus de lecture de données (BL₃) de la ligne d'extrémité opposée (L₃), et un deuxième état dans lequel ils relient l'autre entrée de données (E2) au bus d'écriture (BE₃) de la ligne d'extrémité opposée (L3) et l'autre sortie de données (S2) au bus de lecture (BL₁) de ladite première ligne d'extrémité (L1), et reliant dans leurs deux états le bus de lecture de chaque ligne au bus d'écriture de la ligne voisine, et
- des moyens (MG , BCLⱼ , BCEⱼ) aptes à commander séquentiellement et cycliquement, par paires de colonnes de la matrice, l'écriture et la lecture, respectivement, de données dans toutes les cellules des deux colonnes de la paire concernée selon un ordre pour les rangs successifs desdites colonnes, prédéterminé et différent dans chacun des deux états.

2. Dispositif selon la revendication 1, caractérisé par le fait que le dispositif est cadencé par un signal d'horloge de fréquence prédéterminée, par le fait que les moyens de commande comprennent un bus de commande d'écriture (BCEⱼ) et un bus de commande de lecture (BCLⱼ) pour chaque colonne (Cⱼ) de la matrice et sur lesquels sont respectivement connectées les entrées de commande d'écriture et de lecture de toutes les cellules de la colonne, ainsi que des moyens de génération (MG) aptes à générer à chaque coup d'horloge, sur un bus de commande d'écriture et un bus de commande de lecture associés à deux colonnes différentes, des signaux respectifs de commande d'écriture et de commande de lecture, selon la séquence de rangs correspondant à l'un ou l'autre des deux états.

3. Dispositif selon la revendication 2 ou 3, caractérisé par le fait que selon une première séquence, les signaux de commande de lecture et d'écriture parcourent simultanément et successivement les colonnes de rangs consécutifs de la matrice selon un premier sens prédéterminé, tandis que selon la deuxième séquence, les signaux de commande de lecture et d'écriture parcourent simultanément et successivement les colonnes de rangs consécutifs selon un deuxième sens opposé au premier, et par le fait que dans les deux séquences, le signal de commande de lecture est décalé d'une colonne par rapport au signal de commande d'écriture dans le sens de parcours correspondant.

4. Dispositif selon la revendication 3, caractérisé par le fait que les moyens de génération (MG) comportent pour chaque colonne, un circuit de retard (Rⱼ) cadencé par ledit signal d'horloge, à l'entrée et à la sortie duquel sont respectivement connectés les bus de commande d'écriture et de lecture associés à ladite colonne, ainsi qu'un duplexeur commandable (D_{j,j+1}) connecté entre chaque paire de circuits de retard (Rⱼ Rⱼ₊₁) consécutifs, l'une des entrées (e1) du duplexeur étant reliée à la sortie de l'un des circuits de retard de ladite paire et au bus de commande de lecture de la colonne correspondante, tandis que la sortie (s) du duplexeur est reliée à l'entrée de l'autre circuit de retard de la paire ainsi qu'au bus de commande d'écriture de la colonne correspondante, et que la sortie de cet autre circuit de retard est rebouclée sur l'autre entrée (e2) du duplexeur de la paire précédente, les deux positions différentes des duplexeurs correspondant aux deux états des moyens de commutation, et par le fait que les différents signaux de commande d'écriture et de lecture consistent en une information de commande se propageant cycliquement dans les moyens de génération au rythme du signal d'horloge.

5. Dispositif selon l'une des revendications précédentes, caractérisé par le fait que les cellules de mémorisation sont des points mémoires dynamiques à trois transistors (T1, T2, T3) et par le fait que le bus de lecture d'une ligne est relié au bus d'écriture de la ligne voisine par un inverseur (I_{i+1,i}).

6. Dispositif selon l'une des revendications précédentes caractérisé par le fait que les moyens de commutation comportent des transistors à effet de champ commandés par des signaux d'horloge complémentaires.

7. Dispositif selon l'une des revendications précédentes, caractérisé par le fait que la matrice comporte n lignes et p+1 colonnes, le produit n.p représentant le nombre maximum de données à stocker.

8. Dispositif selon l'une des revendications précédentes, caractérisé par le fait que chaque donnée étant un mot de b bits, il comprend b ensembles-mémoires (PM) identiques, disposés en parallèle, fonctionnant de manière synchronisée, et destinés à stocker respectivement les b bits de chacune des données successives (d1...dn).

9. Utilisation du dispositif selon l'une des revendications précédentes, caractérisée par le fait que les moyens de commutation sont dans l'un quelconque des deux états pendant le stockage du jeu de données, et par le fait que l'on maintient ultérieurement dans cet état les moyens de commutation, conférant ainsi au dispositif une structure de mémoire du type "Premier Entré-Premier Sorti".

10. Utilisation du dispositif selon l'une des revendications 1 à 8, caractérisée par le fait que les moyens de commutation sont dans l'un quelconque des deux états pendant le stockage du jeu de données, et par le fait que l'on fait passer les moyens de commutation dans leur autre état après le stockage du jeu de données, conférant ainsi au dispositif une structure de mémoire du type "Dernier Entré-Premier sorti".
